# EUROPEAN PATENT APPLICATION

(11) **EP 4 455 208 A1**
(43) Date of publication of application: **30.10.2024**
(21) Application number: 22911157.0
(22) Date of filing: 19.12.2022
(51) Int. Cl.: C08L 67/00, C08K 3/04, C08K 7/06, C08L 63/00

(54) **THERMOPLASTIC POLYESTER RESIN COMPOSITION AND MOLDED ARTICLE**

(30) Priority: 23.12.2021 JP 2021209454
(71) Applicant: Toray Industries, Inc., Tokyo 103-8666 (JP)
(72) Inventor: MORIOKA, Nobuhiro, Nagoya-shi, Aichi 455-8502 (JP); SUGISAWA, Koshiro, Nagoya-shi, Aichi 455-8502 (JP)
(74) Representative: Mewburn Ellis LLP
(86) International application number: PCT/JP2022/046610
(87) International publication number: WO 2023/120455

(57) **Abstract**

Provided is a thermoplastic polyester resin composition containing 100 parts by weight of a thermoplastic polyester resin (A), 0.1 to 10 parts by weight of a compound (B) having in each molecule 2 or more functional groups capable of reacting with a carboxy group, and 0.1 to 25 parts by weight of a carbon-based nanofiller (C), in which a content of a metal component in the resin composition is 1,000 ppm or less. A polyester resin composition that can provide a molded article that has high electromagnetic wave absorbing properties, excellent mechanical strength, and excellent hydrolysis resistance is obtained.

## Description

### TECHNICAL FIELD

The present invention relates to a polyester resin composition excellent in electromagnetic wave absorbing properties, mechanical strength, and hydrolysis resistance, and a molded article.

### BACKGROUND ART

Thermoplastic polyester resins, particularly polybutylene terephthalate-based resins, are excellent in injection moldability, lightweight properties, molding processability, mechanical properties, and heat resistance and thus widely used for housings and structural members of office automation equipment, communication equipment, electrical and electronic equipment, and automobile electrical equipment, and the demand thereof is increasing year by year.

On the other hand, with the spread of 5G communication and automatic driving technology for realizing a safer and more comfortable society, it is expected that the use range of high-frequency electromagnetic waves will be further expanded in the future in communication equipment such as a wireless communication system and automobile electrical equipment such as a millimeter wave radar used for the 5G communication and the automatic driving technology.

However, as the electromagnetic wave has a higher frequency, noise is more likely to be emitted when the electromagnetic wave is transmitted, and there is also a problem that communication equipment or automobile electrical equipment malfunctions due to deterioration of an internal noise environment. For example, in a millimeter wave radar, a radio wave reflected by a structure such as a guardrail is mixed with a radio wave reflected from a target to be detected by the radar, so that a false image that does not actually exist may appear on a radar screen.

In order to prevent such malfunctions, housings and structural members used for communication equipment and automotive electrical equipment are required to have excellent radio wave absorbing properties while maintaining excellent injection moldability, lightweight properties, molding processability, mechanical properties, and heat resistance.

To solve the above problem, Patent Document 1 discloses an electromagnetic wave shielding and absorbing molding made of a thermoplastic resin composition containing a thermoplastic resin and carbon black.

Further, Patent Document 2 discloses a radar cover-use resin composition containing carbon nanotubes and a polymer.

### PRIOR ART DOCUMENT

### PATENT DOCUMENTS

Patent Document 1: Japanese Patent Laid-open Publication No. 2019-161210
Patent Document 2: National Publication of International Patent Application No. 2017-507211

### SUMMARY OF THE INVENTION

### PROBLEMS TO BE SOLVED BY THE INVENTION

Thermoplastic polyester resins are deteriorated by hydrolysis. In order to be used as an industrial material for mechanical parts, electrical/communication parts, automobile parts, and the like, it is also required to have hydrolysis resistance for a long period of time in addition to mechanical properties and electromagnetic wave absorbing properties. However, in Patent Document 1, since a large amount of graphite is added, the mechanical strength of the resin composition is reduced, and hydrolysis resistance is not sufficient. In Patent Document 2, although electromagnetic wave absorption and mechanical strength are good, hydrolysis resistance of the resin composition is not sufficient.

Therefore, an object of the present invention is to provide a resin composition having good electromagnetic wave absorbing properties, excellent mechanical strength, and excellent hydrolysis resistance of a molded article, and a molded article thereof.

### SOLUTIONS TO THE PROBLEMS

To solve the above-described problems, the present invention includes the following configurations.
(1) A thermoplastic polyester resin composition containing 100 parts by weight of a thermoplastic polyester resin (A), 0.1 to 10 parts by weight of a compound (B) having in each molecule 2 or more functional groups capable of reacting with a carboxy group, and 0.1 to 25 parts by weight of a carbon-based nanofiller (C), in which the content of a metal component in the resin composition is 1,000 ppm or less.
(2) The thermoplastic polyester resin composition according to (1), in which the thermoplastic polyester (A) contains polybutylene terephthalate as a main component.
(3) The thermoplastic polyester resin composition according to (1) or (2), in which the compound (B) having in each molecule two or more functional groups capable of reacting with a carboxy group is an epoxy compound.
(4) The thermoplastic polyester resin composition according to any one of (1) to (3), in which the carbon-based nanofiller (C) is a carbon nanotube.
(5) The thermoplastic polyester resin composition according to any one of (1) to (4), in which the metal component in the resin composition is at least one selected from aluminum, magnesium, and iron.
(6) The thermoplastic polyester resin composition according to any one of (1) to (5), having an electromagnetic wave absorbing property.
(7) A molded article being obtained by molding the thermoplastic polyester resin composition according to any one of (1) to (6).

### EFFECTS OF THE INVENTION

The present invention can provide a resin composition that can provide a molded article that has high electromagnetic wave absorbing properties, excellent mechanical strength, and excellent hydrolysis resistance. Therefore, the thermoplastic polyester resin composition of the present invention is useful as an electromagnetic wave absorbing molding for various applications.

### EMBODIMENT OF THE INVENTION

Hereinafter, the present invention will be described in detail.

A thermoplastic polyester resin (A) used in the present invention is a polymer or copolymer having, as a main structural unit, at least one residue selected from the group consisting of (1) a residue of a dicarboxylic acid or an ester-forming derivative thereof and a residue of a diol or an ester-forming derivative thereof, (2) a residue of a hydroxycarboxylic acid or an ester-forming derivative thereof, and (3) a residue of a lactone. Here, the expression "as a main structural unit" refers to having 50 mol% or more of at least one residue selected from the group consisting of (1) to (3) in all the structural units. It is a preferred aspect that these residues are present in an amount of 80 mol% or more. Among these, a polymer or copolymer having (1) the residue of a dicarboxylic acid or an ester-forming derivative thereof and the residue of a diol or an ester-forming derivative thereof as a main structural unit is preferred from the viewpoint of more excellent mechanical properties and heat resistance.

Examples of the dicarboxylic acid or the ester-forming derivative thereof include aromatic dicarboxylic acids such as terephthalic acid, isophthalic acid, phthalic acid, 2,6-naphthalenedicarboxylic acid, 1,5-naphthalenedicarboxylic acid, bis(p-carboxyphenyl)methane, 1,4-anthracenedicarboxylic acid, 1,5-anthracenedicarboxylic acid, 1,8-anthracenedicarboxylic acid, 2,6-anthracenedicarboxylic acid, 9,10-anthracenedicarboxylic acid, 4,4'-diphenyl ether dicarboxylic acid, tetrabutylphosphonium 5-isophthalate, and sodium 5-sulfoisophthalate; aliphatic dicarboxylic acids such as oxalic acid, succinic acid, adipic acid, sebacic acid, azelaic acid, dodecanedioic acid, malonic acid, glutaric acid, and dimer acid; alicyclic dicarboxylic acids such as 1,3-cyclohexanedicarboxylic acid and 1,4-cyclohexanedicarboxylic acid; and ester-forming derivatives thereof. Two or more of these may be used.

Examples of the diol or the ester-forming derivative thereof include aliphatic or alicyclic glycols having 2 to 20 carbon atoms such as ethylene glycol, propylene glycol, 1,4-butanediol, neopentyl glycol, 1,5-pentanediol, 1,6-hexanediol, decamethylene glycol, cyclohexanedimethanol, cyclohexanediol, and dimer diol; long-chain glycols having a molecular weight of 200 to 100,000 such as polyethylene glycol, poly-1,3-propylene glycol, and polytetramethylene glycol; aromatic dioxy compounds such as 4,4'-dihydroxybiphenyl, hydroquinone, t-butylhydroquinone, bisphenol A, bisphenol S, and bisphenol F; and ester-forming derivatives thereof. Two or more of these may be used.

Examples of the polymer or copolymer having a dicarboxylic acid or an ester-forming derivative thereof and a diol or an ester-forming derivative thereof as a structural unit include aromatic polyester resins such as polyethylene terephthalate, polypropylene terephthalate, polybutylene terephthalate, polypropylene isophthalate, polybutylene isophthalate, polybutylene naphthalate, polypropylene isophthalate/terephthalate, polybutylene isophthalate/terephthalate, polypropylene terephthalate/naphthalate, polybutylene terephthalate/naphthalate, polybutylene terephthalate/decane dicarboxylate, polypropylene terephthalate/sodium 5-sulfoisophthalate, polybutylene terephthalate/sodium 5-sulfoisophthalate, polypropylene terephthalate/polyethylene glycol, polybutylene terephthalate/polyethylene glycol, polypropylene terephthalate/polytetramethylene glycol, polybutylene terephthalate/polytetramethylene glycol, polypropylene terephthalate/isophthalate/polytetramethylene glycol, polybutylene terephthalate/isophthalate/polytetramethylene glycol, polybutylene terephthalate/succinate, polypropylene terephthalate/adipate, polybutylene terephthalate/adipate, polypropylene terephthalate/sebacate, polybutylene terephthalate/sebacate, polypropylene terephthalate/isophthalate/adipate, polybutylene terephthalate/isophthalate/succinate, polybutylene terephthalate/isophthalate/adipate, and polybutylene terephthalate/isophthalate/sebacate. One of these polymers and copolymers may be used singly, or two or more may be used in combination. Here, "/" represents a copolymer.

Among these, from the viewpoint of further improving mechanical properties and heat resistance, a polymer or copolymer having a residue of an aromatic dicarboxylic acid or an ester-forming derivative thereof and a residue of an aliphatic diol or an ester-forming derivative thereof as a main structural unit is more preferred, and a polymer or copolymer having a residue of terephthalic acid, naphthalenedicarboxylic acid, or an ester-forming derivative thereof and a residue of an aliphatic diol selected from ethylene glycol, propylene glycol, and 1,4-butanediol, or an ester-forming derivative thereof as a main structural unit is further preferred.

Among them, at least one aromatic polyester resin selected from polyethylene terephthalate, polypropylene terephthalate, polybutylene terephthalate, polypropylene naphthalate, polybutylene naphthalate, polypropylene isophthalate/terephthalate, polybutylene isophthalate/terephthalate, polypropylene terephthalate/naphthalate, polybutylene adipate/terephthalate, polybutylene terephthalate/sebacate, polybutylene terephthalate/naphthalate, and the like is preferable, and at least one selected from polyethylene terephthalate, polybutylene terephthalate, polybutylene isophthalate/terephthalate, polybutylene decane dicarboxylate/terephthalate, polybutylene terephthalate/naphthalate, and polybutylene/ethylene terephthalate is more preferable. Polybutylene terephthalate is more preferable from the viewpoint of excellent balance between mechanical properties and molding processability. In addition, two or more kinds of them can be used in an arbitrary content, but polybutylene terephthalate is preferably used as a main component. Here, the "main component" means that 50 wt% or more of the thermoplastic polyester resin (A) blended in the resin composition is polybutylene terephthalate.

The carboxy group concentration of the thermoplastic polyester resin (A) used in the present invention is preferably 50 eq/t or less from the viewpoints of suppression of deterioration in mechanical properties during melt-kneading and residence, and moldability. The lower limit value of the carboxy group concentration is 0 eq/t. Here, the carboxy group concentration in the thermoplastic polyester resin (A) is a value measured by dissolving the thermoplastic polyester resin (A) in an o-cresol/chloroform solvent, and then titrating the resulting solution with ethanolic potassium hydroxide.

The thermoplastic polyester resin (A) used in the present invention preferably has a weight average molecular weight (Mw) of 8,000 or more, from the viewpoint of further improving mechanical properties. When the weight average molecular weight (Mw) is 500,000 or less, fluidity can be improved, which is preferable. The weight average molecular weight (Mw) is more preferably 300,000 or less, even more preferably 250,000 or less. In the present invention, the weight average molecular weight (Mw) of the thermoplastic polyester resin (A) is a value in terms of polymethyl methacrylate (PMMA) measured by gel permeation chromatography (GPC) using hexafluoroisopropanol as a solvent.

The intrinsic viscosity of the thermoplastic polyester resin (A) used in the present invention is preferably 0.36 dl/g or more, more preferably 0.50 dl/g or more when the o-chlorophenol solution is measured at 25°C from the viewpoint of further improving the mechanical properties. In addition, the intrinsic viscosity is preferably 1.60 dl/g or less, more preferably 1.50 dl/g or less from the viewpoint of being able to improve fluidity.

The thermoplastic polyester resin (A) used in the present invention can be produced by a polycondensation method, a ring-opening polymerization method, or the like, which is well known. The production method may be either batch polymerization or continuous polymerization. Either polymerization by transesterification or direct polymerization may be employed. From the viewpoint of productivity, continuous polymerization is preferable, and direct polymerization is more preferably used.

When the thermoplastic polyester resin (A) used in the present invention is a polymer or copolymer that is obtained by a condensation reaction and has a dicarboxylic acid or an ester-forming derivative thereof and a diol or an ester-forming derivative thereof as main components, the dicarboxylic acid or an ester-forming derivative thereof and the diol or an ester-forming derivative thereof can be produced by performing an esterification reaction or transesterification reaction and then performing a polycondensation reaction.

The thermoplastic polyester resin composition of the present invention (hereinafter referred to as the resin composition of the present invention) further contains a compound (B) having in each molecule two or more functional groups capable of reacting with a carboxy group (hereinafter it may be referred to as the compound (B)). In the thermoplastic polyester resin (A), ester bonds are easily decomposed by hydrolysis, and as a result, the carboxy group concentration in the thermoplastic polyester resin composition increases. As the carboxy group concentration increases, the reduction in the molecular weight of the thermoplastic polyester resin (A) is promoted, and the mechanical properties are deteriorated. In the present invention, by blending the compound (B) together with the thermoplastic polyester resin (A), the carboxy group of the thermoplastic polyester resin (A) generated by hydrolysis reacts with the functional group of the compound (B) to suppress an increase in the carboxy group concentration. As a result, high mechanical properties of the thermoplastic polyester resin (A) can be maintained.

Examples of the compound (B) include an epoxy compound, an oxazoline compound, and a carbodiimide compound.

The epoxy compound is a compound having an epoxy group as a functional group capable of reacting with a carboxy group and is not particularly limited as long as it has two or more epoxy groups in one molecule. Examples of the epoxy compound having two or more epoxy groups in one molecule include a glycidyl ether type epoxy resin, a glycidyl ester type epoxy resin, a glycidyl amine type epoxy resin, an alicyclic epoxy resin, a heterocyclic epoxy resin, and a glycidyl group-containing copolymer containing a glycidyl ester of an α-olefin and an α,β-unsaturated acid as copolymerization components. They may be used singly or in combination of two or more thereof.

Examples of the glycidyl ether type epoxy resin include a condensate of a phenol compound and epichlorohydrin, novolac-type epoxy, and a glycidyl ether of a polyvalent hydroxy group compound.

Specific examples of the condensate of a phenol compound and epichlorohydrin include condensates obtained by condensation of epichlorohydrin with phenol compounds such as bisphenol A, resorcinol, hydroquinone, pyrocatechol, bisphenol F, saligenin, bisphenol S, 4,4'-dihydroxybiphenyl, 1,5-dihydroxynaphthalene, 1,4-dihydroanthracene-9,10-diol, 6-hydroxy-2-naphthoic acid, 1,1-methylenebis-2,7-dihydroxynaphthalene, 1,1,2,2-tetrakis-4-hydroxyphenylethane, and cashew phenol.

Specific examples of the bisphenol A type epoxy include jER 1004 (manufactured by Mitsubishi Chemical Corporation), and specific examples of the bisphenol F type epoxy include jER 4005P (manufactured by Mitsubishi Chemical Corporation).

Specific examples of the novolac-type epoxy include phenol novolac-type epoxy, cresol novolac-type epoxy, naphthol novolac-type epoxy, bisphenol A novolac-type epoxy, dicyclopentadiene-phenol-added novolac-type epoxy, dimethylenephenylene-phenol-added novolac-type epoxy, and dimethylenebiphenylene-phenol-added novolac-type epoxy.

Specific examples of the phenol novolac-type epoxy include EPPN-201 (manufactured by Nippon Kayaku Co., Ltd.), specific examples of the cresol novolac-type epoxy include EOCN-102S (manufactured by Nippon Kayaku Co., Ltd.), and specific examples of the dicyclopentadiene-phenol-added novolac-type epoxy include HP-7200H (manufactured by DIC Corporation).

The polyvalent hydroxy group compound is an aliphatic compound having 2 or more hydroxy groups, and specific examples thereof include glycols having 2 to 20 carbon atoms, glycerin, polyglycerin, dipentaerythritol, tripentaerythritol, xylitol, mannitol, sorbitol, galactose, maltitol, lactitol, isomalt, inositol, glucose, and fructose.

Examples of the glycidyl ester-type epoxy resin include epoxy resins produced from epichlorohydrin and phthalic acid, tetrahydrophthalic acid, p-oxybenzoic acid, or dimer acid, trimesic acid triglycidyl ester, trimellitic acid triglycidyl ester, pyromellitic acid tetraglycidyl ester, epoxidized fatty acid octyl ester, epoxidized soybean oil, and epoxidized linseed oil.

Examples of the glycidylamine-type epoxy resin include epoxy resins produced from epichlorohydrin, aniline, diaminodiphenylmethane, p-aminophenol, meta-xylylenediamine, or 1,3-bis(aminomethyl)cyclohexane, tetraglycidylaminodiphenylmethane, triglycidyl-para-aminophenol, triglycidyl-meta-aminophenol, tetraglycidyl-meta-xylenediamine, tetraglycidylbisaminomethylcyclohexane, triglycidyl cyanurate, and triglycidyl isocyanurate.

Examples of the alicyclic epoxy resin include compounds having a cyclohexene oxide group, a tricyclodecene oxide group, and a cyclopentene oxide group.

Examples of the heterocyclic epoxy resin include epoxy resins produced from epichlorohydrin and hydantoin or isocyanuric acid.

Among them, a glycidyl ether-type epoxy resin is preferable from the viewpoint of suppressing a reaction between epoxy groups of the compound (B) and suppressing deterioration of residence stability.

Examples of the oxazoline compound include compounds having an oxazoline group as a functional group capable of reacting with a carboxy group, such as 2,2'-bis(2-oxazoline), 2,2'-ethylene-bis(4,4'-dimethyl-2-oxazoline), 2,2'-p-phenylene-bis(2-oxazoline), and bis(2-oxazolinylcyclohexane) sulfide, and oxazoline group-containing polymers. These can be used singly or in combination of two or more kinds thereof. Among them, an oxazoline group-containing polymer is preferable from the viewpoint of ease of handling. The oxazoline group-containing polymer is obtained by addition polymerizable oxazoline polymerization of 2-vinyl-2-oxazoline, 2-vinyl-4-methyl-2-oxazoline, 2-isopropenyl-2-oxazoline, or the like. Other monomers may be copolymerized as necessary. The polymerization method of the oxazoline group-containing polymer is not particularly limited, and various known polymerization methods can be adopted.

The carbodiimide compound is a compound containing a carbodiimide group as a functional group capable of reacting with a carboxy group, and examples thereof include dicarbodiimides such as N,N'-diisopropylcarbodiimide, N,N'-dicyclohexylcarbodiimide, and N,N'-di-2,6-diisopropylphenylcarbodiimide; and polycarbodiimides such as poly(1,6-hexamethylenecarbodiimide), poly(4,4'-methylenebiscyclohexylcarbodiimide), poly(1,3-cyclohexylenecarbodiimide), poly(1,4-cyclohexylenecarbodiimide), poly(4,4'-dicyclohexylmethanecarbodiimide), poly(4,4'-diphenylmethanecarbodiimide), poly(3,3'-dimethyl-4,4'-diphenylmethanecarbodiimide), poly(naphthalenecarbodiimide), poly(p-phenylenecarbodiimide), poly(m-phenylenecarbodiimide), poly(tolylcarbodiimide), poly(diisopropylcarbodiimide), poly(methyl-diisopropylphenylenecarbodiimide), poly(1,3,5-triisopropylbenzene)polycarbodiimide, poly(1,3,5-triisopropylbenzene)polycarbodiimide, poly(1,5-diisopropylbenzene) polycarbodiimide, poly(triethylphenylenecarbodiimide), and poly(triisopropylphenylenecarbodiimide).

Among them, an epoxy compound having an epoxy group as a functional group capable of reacting with a carboxy group is more preferable from the viewpoint that the epoxy compound also reacts with the hydroxy group terminal of the thermoplastic polyester resin (A), post-crystallization at the time of hydrolysis of the resin composition can be suppressed, and hydrolysis resistance can be further improved.

In the resin composition of the present invention, the content of the compound (B) is 0.1 parts by weight or more and 10 parts by weight or less with respect to 100 parts by weight of the thermoplastic polyester resin (A). When the content of the compound (B) is less than 0.1 parts by weight, hydrolysis resistance is deteriorated. The content is more preferably 0.3 parts by weight or more, still more preferably 0.4 parts by weight or more, still more preferably 0.5 parts by weight or more. On the other hand, when the content of the compound (B) exceeds 10 parts by weight, the mechanical strength and retention stability are deteriorated, and production becomes difficult due to thickening. The content is more preferably 8 parts by weight or less, still more preferably 5 parts by weight or less.

The resin composition of the present invention further contains a carbon-based nanofiller (C). Containing the carbon-based nanofiller (C) makes it possible to improve the electromagnetic wave absorbing properties while improving the strength of the resin composition.

Examples of the carbon-based nanofiller (C) include anisotropic carbon-based nanofillers such as carbon nanofibers, carbon nanohorns, carbon nanocones, carbon nanotubes, carbon nanocoils, carbon nanotwists, carbon nanoballoons, carbon nanowalls, graphene, nanographene, graphene nanoribbons, and derivatives thereof, and fullerenes and derivatives thereof. These carbon-based nanofillers may be used singly or in combination of two or more thereof.

Among such carbon-based nanofillers, anisotropic carbon-based nanofillers are preferable because dielectric loss is likely to occur and radio wave absorbing properties can be further improved. From the viewpoint of further improving thermal conductivity, carbon nanofibers, carbon nanohorns, carbon nanocones, carbon nanotubes, carbon nanocoils, carbon nanowalls, and carbon nanochaplets are more preferable, and among them, carbon nanofibers, carbon nanohorns, carbon nanotubes, and carbon nanocoils are particularly preferable.

The average diameter of the carbon-based nanofiller (C) is not particularly limited but is preferably 1,000 nm or less, more preferably 300 nm or less, particularly preferably 100 nm or less. When the average diameter is 1,000 nm or less, dielectric loss is likely to occur, and radio wave absorbing properties can be further improved. The average diameter of the carbon-based nanofiller (C) is preferably 0.1 nm or more, more preferably 0.5 nm or more, particularly preferably 1.0 nm or more. When the average diameter is 0.1 nm or more, bundles are less likely to be formed, and fine dispersion is likely to occur in the resin composition, so that mechanical strength and radio wave absorbing properties can be further improved. The average diameter was calculated as an average value by observing the carbon-based nanofiller (C) on a transmission electron microscope and measuring the diameters of 100 or more pieces of the carbon-based nanofiller (C). When the cross section of the carbon-based nanofiller (C) was not circular but flat or the like, the average value of the minor axis and the major axis was taken as the diameter. When the carbon-based nanofiller (C) was a substance having a large aspect ratio, such as carbon nanofibers and carbon nanotubes, the diameter of the cross section in the longitudinal direction of the shape was taken as the diameter.

Many carbon-based nanofillers (C) include metal components derived from synthetic catalysts, such as iron, cobalt, chromium, manganese, molybdenum, tungsten, vanadium, tin, copper, calcium, and nickel, and metal components derived from catalyst supports, such as magnesium compounds, silicon oxide, aluminum oxide, zeolite, and titanium oxide. The inventors have found that these metal components promote the hydrolysis of the polyester resin by the terminal carboxy group of the thermoplastic polyester resin (A), promote the self-reaction of the functional group of the compound (B), suppress the reaction between the terminal carboxy group of the thermoplastic polyester resin (A) and the functional group of the compound (B), and as a result, lower the hydrolysis resistance of the resin composition. In the present invention, it is preferable to reduce the content of the metal component in the carbon-based nanofiller (C), so that the content of the metal component in the resin composition can be reduced as described later, thereby improving the hydrolysis resistance of the resin composition. Among them, it is preferable that the content of a metal component derived from a catalyst support such as iron, a magnesium compound, aluminum oxide, zeolite, and titanium oxide, which is free without being incorporated into the carbon-based nanofiller after synthesis and is likely to adversely affect the terminal carboxy group of the thermoplastic polyester resin (A) and the functional group of the compound (B), that is, a metal selected from iron, magnesium, and aluminum as the metal component, is low. The metal component in the carbon-based nanofiller (C) can be specified by elementary analysis using fluorescent X-rays.

The amount of the metal component contained in the carbon-based nanofiller (C) is preferably 2 wt% or less with respect to 100 wt% of the carbon-based nanofiller (C). By setting the amount of the metal component in the carbon-based nanofiller (C) to 2 wt% or less, the content of the metal component in the resin composition can be suppressed, hydrolysis of the polyester resin by the carboxy group present at the terminal of the thermoplastic polyester resin (A) can be suppressed, self-reaction of the functional group of the compound (B) can be suppressed, reactivity between the carboxy group of the thermoplastic polyester resin (A) and the functional group of the compound (B) can be improved, and hydrolysis resistance is improved.

The method for setting the amount of the metal component contained in the carbon-based nanofiller (C) to 2 wt% or less is not particularly limited, and examples thereof include a method of producing a carbon-based nanofiller without using a catalyst support such as a magnesium compound, silicon oxide, aluminum oxide, zeolite, and titanium oxide, a method of dissolving and removing a metal by adding an acid to a carbon-based nanofiller, and a method of removing a metal component by passing a carbon-based nanofiller through a magnetic field.

The amount of the metal component contained in the carbon-based nanofiller can be measured as the amount of the metal element using a fluorescent X-ray analyzer.

The content of the carbon-based nanofiller (C) in the present invention is 0.1 to 25 parts by weight with respect to 100 parts by weight of the thermoplastic polyester resin (A). When the content of the carbon-based nanofiller (C) is less than 0.1 parts by weight, electromagnetic wave absorbing properties are deteriorated. The content is preferably 2 parts by weight or more, more preferably 3 parts by weight or more. In addition, when the content of the carbon-based nanofiller (C) exceeds 25 parts by weight, mechanical strength and fluidity are deteriorated. The content is preferably 20 parts by weight or less, more preferably 15 parts by weight or less, further preferably 10 parts by weight or less.

The resin composition of the present invention preferably further includes a fibrous reinforcing material (D). By containing the fibrous reinforcing material (D), the mechanical strength of the molded article can be improved. Examples of the fibrous reinforcing material (D) include glass fibers, aramid fibers, and cellulose fibers, and among them, glass fibers can be preferably used. In the present invention, a compound also corresponding to the carbon-based nanofiller (C) such as carbon nanofibers among the fibrous reinforcing material (D) is handled as the component (C).

The fibrous reinforcing material (D) may have a circular cross section or a flat cross section. It is also possible to use hollow fibers for the purpose of, for example, reducing the specific gravity. As the cross-sectional area of the fibrous reinforcing material (D) increases, a sufficient reinforcing effect becomes difficult to obtain. On the other hand, when the cross-sectional area is too small, it is difficult to produce the fibrous reinforcing material, and there is also a problem that it is difficult to handle the fibrous reinforcing material. The cross-sectional area of the fibrous reinforcing material (D) in the present invention is preferably 2 × 10⁻⁵ to 8 × 10⁻³ mm², more preferably 8 × 10⁻⁵ to 8 × 10⁻³ mm², still more preferably 8 × 10⁻⁵ to 8 × 10⁻⁴ mm².

The fiber length of the fibrous reinforcing material (D) is not particularly limited. The fiber length is preferably 30 um or more from the viewpoint of mechanical characteristics and is preferably 50 to 1,000 um according to the required performance although the fiber length is preferably short in order to reduce the amount of deformation of the molded article in view of the balance between mechanical characteristics and deformation suppression of the molded article.

In the fibrous reinforcing material (D) used in the present invention, it is preferable to use a sizing agent or a surface treatment agent as necessary. The sizing agent or the surface treatment agent is a functional compound such as an epoxy-based compound, an isocyanate-based compound, and a silane-based compound. These compounds may be used in advance for surface-treating or sizing the fibrous reinforcing material or added simultaneously with the fibrous reinforcing material during material preparation.

In the case where the resin composition of the present invention contains the fibrous reinforcing material (D), the content thereof is preferably 1 part by weight or more and 100 parts by weight or less with respect to 100 parts by weight of the thermoplastic polyester resin (A). When the content of the fibrous reinforcing material (D) is 1 part by weight or more, the mechanical strength of the molded article can be further improved. The content is preferably 10 parts by weight or more, more preferably 20 parts by weight or more. When the content of the fibrous reinforcing material (D) is 100 parts by weight or less, a decrease in fluidity can be suppressed. The content is preferably 80 parts by weight or less, more preferably 50 parts by weight or less.

It is preferable that the resin composition of the present invention further contain a vinyl copolymer (E). By containing the vinyl copolymer (E), the dimensional stability is improved, so that the radio wave absorbing properties of the molded article can be stabilized regardless of the molding conditions. The vinyl copolymer (E) used in the present invention is a copolymer containing at least a unit derived from an unsaturated nitrile-based monomer and a unit derived from an aromatic vinyl-based monomer as constituent units, and other copolymerizable monomers can be copolymerized as necessary. In general, these vinyl copolymers (E) are produced by emulsion polymerization, bulk polymerization, or bulk/suspension polymerization, but are not limited thereto.

The unsaturated nitrile-based monomer used for the vinyl copolymer (E) is not particularly limited, and examples thereof include acrylonitrile, methacrylonitrile, and ethacrylonitrile, and among them, acrylonitrile is preferable. The aromatic vinyl-based monomer is not particularly limited, and specific examples thereof include styrene, α-methylstyrene, o-methylstyrene, p-methylstyrene, o-ethylstyrene, p-ethylstyrene, and p-t-butylstyrene, and among them, styrene and α-methylstyrene are preferably used. Examples of other copolymerizable monomers include acrylic acid and methacrylic acid ester compounds such as butyl acrylate, ethyl acrylate, and methyl methacrylate, N-phenylmaleimide, and maleic anhydride. Among them, a styrene-acrylonitrile copolymer (hereinafter abbreviated as AS resin) containing acrylonitrile as an unsaturated nitrile-based monomer, styrene as an aromatic vinyl-based monomer, and 15 mass% or less of other copolymerizable monomers is preferable. The vinyl copolymer (E) may contain a rubber-like polymer as long as scratch resistance is not largely impaired. A resin obtained by grafting an unsaturated nitrile-based monomer and an aromatic vinyl-based monomer to the rubber-like polymer, and a resin obtained by copolymerizing another copolymerizable monomer are also included. Monomers similar to the monomers shown above can be used as the unsaturated nitrile-based monomer, aromatic vinyl-based monomer, and other copolymerizable monomers to be used. The rubber-like polymer used for the vinyl copolymer (E) is not particularly limited, but diene-based rubber, acrylic rubber, ethylene-based rubber, and the like can be used. Specific examples of these rubber-like polymers include polybutadiene, a styrene-butadiene copolymer, a block copolymer of styrene-butadiene, an acrylonitrile-butadiene copolymer, a butyl acrylate-butadiene copolymer, polyisoprene, a butadiene-methyl methacrylate copolymer, a butyl acrylate-methyl methacrylate copolymer, a butadiene-ethyl acrylate copolymer, an ethylene-propylene copolymer, an ethylene-propylene-diene-based copolymer, an ethylene-isoprene copolymer, and an ethylene-methyl acrylate copolymer. Among these rubber-like polymers, an acrylic rubber is preferably used.

In addition, the vinyl copolymer (E) is also preferably copolymerized with a raw material monomer forming a glycidyl group-containing vinyl-based unit in order to improve compatibility with the thermoplastic polyester resin (A). Specific examples of the raw material monomer forming the glycidyl group-containing vinyl-based unit include glycidyl esters of unsaturated monocarboxylic acids such as glycidyl (meth)acrylate and glycidyl p-styrylcarboxylate, monoglycidyl esters or polyglycidyl esters of unsaturated polycarboxylic acids such as maleic acid and itaconic acid, and unsaturated glycidyl ethers such as allyl glycidyl ether, 2-methylallyl glycidyl ether, and styrene-4-glycidyl ether. In the present invention, among the vinyl copolymers, even a compound that is copolymerized with a raw material monomer forming a glycidyl group-containing vinyl-based unit and also corresponds to the compound (B) is handled as the component (E) .

In the case where the resin composition of the present invention contains the vinyl copolymer (E), the content thereof is preferably 1 part by weight or more and 100 parts by weight or less with respect to 100 parts by weight of the thermoplastic polyester resin (A). When the content of the vinyl copolymer (E) is 1 part by weight or more, the dimensional stability is improved, so that the radio wave absorbing properties of the molded article can be stabilized regardless of the molding conditions. The content is preferably 10 parts by weight or more, more preferably 20 parts by weight or more. When the content of the vinyl copolymer (E) is 100 parts by weight or less, deterioration of heat resistance can be suppressed. The content is preferably 80 parts by weight or less, more preferably 50 parts by weight or less.

The resin composition of the present invention has a metal component content of 1,000 ppm or less. When the content of the metal component is more than 1,000 ppm, the hydrolysis of the polyester resin by the terminal carboxy group of the thermoplastic polyester resin (A) is promoted, the self-reaction of the functional group of the compound (B) is promoted, the carboxy group of the thermoplastic polyester resin (A) cannot react with the functional group of the compound (B), and the hydrolysis resistance of the resin composition is lowered. The content of the metal component is preferably 500 ppm or less, more preferably 100 ppm or less. The lower limit value of the content of the metal component is 0 ppm.

Examples of a method for quantifying the content of the metal component in the resin composition include atomic absorption spectrometry.

The method for setting the content of the metal component in the resin composition to 1,000 ppm or less is not particularly limited, and examples thereof include use of the carbon-based nanofiller (C) having a small content of the metal component as described above. When the metal component in the resin composition is a component derived from the carbon-based nanofiller (C), the type thereof is at least one selected from iron, magnesium, and aluminum. Therefore, the total amount of metal components selected from iron, magnesium, and aluminum in the resin composition is preferably 1,000 ppm or less, more preferably 500 ppm or less, still more preferably 100 ppm or less.

In the resin composition of the present invention, a thermoplastic resin other than the component (A) may be contained to the extent that the object of the present invention is not impaired, and moldability, toughness, and the like can be improved. Examples of the thermoplastic resin other than the component (A) include a polyamide resin, a polyacetal resin, a polyurethane resin, an aromatic or aliphatic polyketone resin, a polyphenylene sulfide resin, a polyether ether ketone resin, a polyimide resin, a thermoplastic starch resin, a polyarylate resin, a polysulfone resin, a polyether sulfone resin, a phenoxy resin, a polyphenylene ether resin, a polyether imide resin, a cellulose acetate resin, a polyvinyl alcohol resin, and a polyolefin resin. In the case where the resin composition of the present invention contains a thermoplastic resin other than the component (A), the content thereof is preferably 1 part by weight or more and 50 parts by weight or less with respect to 100 parts by weight of the thermoplastic polyester resin (A).

Furthermore, the resin composition of the present invention may contain other components, for example, a stabilizer, a weathering agent (resorcinol type, salicylate type, benzophenone type, and the like), a lubricant (montanic acid and esters thereof, half esters thereof, stearyl alcohol, polyethylene wax, and the like), a pigment, a dye, a crystal nucleating agent (talc, polyether ether ketone, and the like), a plasticizer, an antistatic agent, a flame retardant, a coloring inhibitor, other polymers, and the like as long as the object of the present invention is not impaired.

The resin composition of the present invention can be obtained, for example, by melt-kneading the components (A) and (B), and as necessary, other components.

Examples of the melt-kneading method include a method in which the thermoplastic polyester resin (A), a metal salt (B), and various additives are preliminarily mixed and supplied to an extruder or the like for sufficient melt-kneading, and a method in which a predetermined amount of each component is supplied to an extruder or the like using a fixed amount feeder such as a weight feeder for sufficient melt-kneading.

Examples of the preliminary mixing include a dry blending method and a mixing method using mechanical mixing devices such as a tumble mixer, a ribbon mixer, and a Henschel mixer.

In addition, it is possible to prepare a carbon-based nanofiller masterbatch in which the carbon-based nanofiller (C) is previously blended in the thermoplastic polyester resin at a high concentration and to subject the masterbatch to the melt-kneading. The use of the carbon-based nanofiller masterbatch is preferable from the viewpoint of handleability and uniform dispersibility of the carbon-based nanofiller. In this case, the thermoplastic resin to be used for making the masterbatch of the carbon-based nanofiller may be the thermoplastic polyester resin as the component (A) or may be a resin other than the component (A), such as a polyamide resin, a polycarbonate resin, a styrene-based resin, and a polyethylene resin. From the viewpoint of easily dispersing a high concentration of the carbon-based nanofiller and easily forming the masterbatch, it is preferable to form the masterbatch using the thermoplastic polyester resin (A).

The fibrous reinforcing material (D) may be added through a side feeder installed between the feeding portion and the vent portion of a multi-screw extruder such as a twin-screw extruder. In the case of a liquid additive, a method of adding a liquid additive by installing a liquid feeding nozzle between the feeding portion and the vent portion of a multi-screw extruder such as a twin-screw extruder and using a plunger pump or a method of supplying a liquid additive using a metering pump from the feeding portion or the like may be used.

The resin composition of the present invention is preferably formed into pellets and then subjected to molding processing. Examples of the pelletizing method include a method of melt-kneading the components constituting the resin composition using a single-screw extruder, a twin-screw extruder, a triple-screw extruder, a conical extruder, a kneader-type mixer, or the like equipped with a "uni-melt" or "Dulmage" type screw, extruding the resulting mixture in the form of strands, and then cutting the resulting strands using a strand cutter.

By melt-molding the resin composition of the present invention, a molded article in the form of a film, fiber, and other various types of shapes can be obtained. Examples of the melt-molding method include injection molding, extrusion molding, and blow molding, and injection molding is particularly preferably used.

In addition to a regular injection molding method, other types of injection molding methods are also known such as gas assisted molding, two-color molding, sandwich molding, in-mold molding, insert molding, and injection press molding, and any of the molding methods can also be applied.

The resin composition of the present invention has high electromagnetic wave absorbing properties, excellent mechanical strength, and excellent hydrolysis resistance. The molded article of the present invention is a molded article excellent in electromagnetic wave absorbing properties, mechanical properties, and hydrolysis resistance and can be used for various applications such as automobile components, mechanical mechanism components, and electric and electronic components utilizing the characteristics thereof.

Specific applications include junction boxes, LiBs, insulators, air flow meters, air pumps, thermostat housings, engine mounts, ignition bobbins, ignition cases, clutch bobbins, idle speed control valves, vacuum switching valves, ECU housings, HUD housings, vacuum pump cases, inhibitor switches, rotation sensors, pressure sensors, acceleration sensors, millimeter wave radars, housings of sensing components such as ultrasonic sensors, brackets, and internal components thereof; automotive under-the-hood components such as distributor caps, coil bases, actuator cases for ABS, tops and bottoms of radiator tanks, cooling fans, fan shrouds, engine covers, cylinder head covers, oil caps, oil pans, oil filters, fuel caps, fuel strainers, distributor caps, vapor canister housings, air cleaner housings, timing belt covers, brake booster components, various cases, various tubes, various tanks, various hoses, various clips, various valves, and various pipes; automotive interior components such as torque control levers, safety belt components, register blades, washer levers, window regulator handles, window regulator handle knobs, passing light levers, sun visor brackets, and various motor housings; automotive exterior components such as roof rails, fenders, garnishes, bumpers, door mirror stays, spoilers, hood louvers, wheel covers, wheel caps, grill apron cover frames, lamp reflectors, lamp bezels, and door handles; various automotive connectors such as wire harness connectors, SMJ connectors, PCB connectors, and door grommet connectors; and electrical connectors, relay cases, coil bobbins, optical pickup chassis, motor cases, notebook computer housings and internal components, CRT display housings and internal components, printer housings and internal components, housings and internal components of mobile terminals such as mobile phones, mobile personal computers, and handheld mobile devices, housings and internal components of recording medium (CD, DVD, PD, FDD, etc.) drives, housings and internal components of copiers, housings and internal components of facsimile machines, and housings and internal components of communication electrical and electronic components represented by base stations, data communication modules, various antennas, and the like. Further, home and office electrical appliance components represented by VTR components, television components, irons, hair driers, rice cooker components, microwave oven components, acoustic components, video cameras, video equipment components such as projectors, lighting components, refrigerator components, air conditioner components, typewriter components, word processor components, and the like can be mentioned. Examples also include housings and internal components of electronic musical instruments, home game machines, portable game machines, and the like, various gears, various cases, sensors, LED lamps, connectors, sockets, resistors, relay cases, switches, coil bobbins, capacitors, variable capacitor cases, optical pickups, radiators, and various terminal strips.

Among them, suitable applications include ECU housings, HUD housings, rotation sensors, pressure sensors, acceleration sensors, millimeter wave radars, housings of sensing components such as ultrasonic sensors, brackets, and internal components thereof; notebook computer housings and internal components; CRT display housings and internal components; printer housings and internal components; housings and internal components of mobile terminals such as mobile phones, mobile personal computers, and handheld mobile devices; housings and internal components of recording medium (CD, DVD, PD, FDD, etc.) drives; housings and internal components of copiers; housings and internal components of facsimile machines; housings and internal components of communication electric and electronic components represented by base stations, data communication modules, various antennas, and the like, which particularly require electromagnetic wave absorbing properties.

In the resin composition of the present invention, in the evaluation of electromagnetic wave absorbing properties measured by the method described later, S21 is preferably 7 dB or more, more preferably 10 dB or more at a thickness of 2 mm. When S21 is 7 dB or more, 80% or more of the incident radio wave is attenuated and the transmitted radio wave is 20% or less, so that it is possible to protect the communication equipment and the automobile electrical equipment from the electromagnetic wave noise in the surrounding environment. When S21 is 10 dB or more, the shielding rate of the electromagnetic wave is such that 90% or more is attenuated and the transmitted radio wave is 10% or less, so that the reliability of protecting the device from the electromagnetic wave noise of the surrounding environment can be further enhanced.

In addition, in the resin composition of the present invention, the tensile strength retention of a molded article treated (PCT50h treatment) at a temperature of 121°C and a humidity of 100% RH for 50 hours is preferably 60% or more, more preferably 70% or more as measured by the method described later. When the tensile strength retention after the PCT50h treatment is 60% or more, it is possible to maintain sufficient strength that can withstand practical use even in applications exposed to high temperature and high humidity conditions such as automobile components and electric and electronic components. When the tensile strength retention after the PCT50h treatment is 70% or more, the reliability of the product can be further enhanced.

### EXAMPLES

Next, the present invention will be described in more detail with reference to examples, but these examples do not limit the present invention.

The abbreviations of the main raw materials used in the examples and the contents thereof are summarized below.

(A) Thermoplastic polyester resin
   A-1: Polybutylene terephthalate (terminal carboxy group concentration: 25 eq/t, intrinsic viscosity measured at 25°C using o-chlorophenol solution as solvent: 0.85 dL/g).
   A-2: Polyethylene terephthalate (terminal carboxy group concentration: 25 eq/t, intrinsic viscosity measured at 25°C using o-chlorophenol solution as solvent: 0.80 dL/g).
(B) Compound having in molecule two or more functional groups capable of reacting with carboxy group
   B-1: Epoxy resin (HP7200H manufactured by DIC Corporation)
   B-2: Epoxy resin (jER 1004 manufactured by Mitsubishi Chemical Corporation).
(C) Carbon-based nanofiller
   C-1: Carbon nanotube A (average diameter: 15 nm, BET specific surface area: 187 m²/g, composition: carbon: 96 mass%, magnesium: 1.27 mass%, aluminum: 0.70 mass%, iron: 2.00 mass%)
   C-2: Carbon nanotube B (average diameter: 13 nm, BET specific surface area: 191 m²/g, composition: carbon: 98 mass%, magnesium: 0.001 mass%, aluminum: 0.620 mass%, iron: 0.630 mass%)
   C-3: Carbon nanotube masterbatch

Using a co-rotating twin screw extruder (TEX30α manufactured by The Japan Steel Works, Ltd.) having a screw diameter of 30 mm and L/D of 35 with a vent, 17.6 parts by weight of C-2 (carbon nanotube B) was melt-kneaded with 100 parts by weight of A-1 (polybutylene terephthalate) under the conditions of a cylinder temperature of 250°C and a screw rotation speed of 150 rpm, and pelletized by a strand cutter. Thereafter, the mixture was vacuum-dried at a temperature of 110°C for 6 hours to obtain carbon nanotube masterbatch pellets.

The metal component content in the carbon-based nanofiller (C) was measured using a fluorescent X-ray analyzer Simultix manufactured by Rigaku Corporation.

### (D) Fibrous reinforcing material

D-1: Round-section chopped strand glass fiber (ECS 03 T-187 manufactured by Nippon Electric Glass Co., Ltd.).

### (E) Vinyl copolymer

E-1: Acrylonitrile/styrene/glycidyl methacrylate copolymer (weight ratio of components of acrylonitrile/styrene/glycidyl methacrylate copolymer: 23.7/76.0/0.3, reduced viscosity: 0.72).

The evaluation methods used in examples and comparative examples are summarized below.

### (1) Metal content in resin composition

To 10 ml of sulfuric acid, 0.2 g of the resin composition was added, and nitric acid was further added until the decomposition of the resin composition was completed. The solution was filtered, and the metal content in the obtained filtrate was quantified using an atomic absorption spectrophotometer (ZA3300 manufactured by Hitachi High-Technologies Corporation).

### (2) Tensile properties

An ISO-1A dumbbell test piece for evaluation of tensile properties having a thickness of 4 mm was obtained using a SE50-DUZ injection molding machine manufactured by Sumitomo Heavy Industries, Ltd. When the thermoplastic polyester resin (A) was polybutylene terephthalate, injection molding was performed under the temperature conditions of a molding temperature of 260°C and a mold temperature of 80°C, and under the molding cycle conditions of a total of an injection time and a dwelling time of 10 seconds and a cooling time of 10 seconds. When the thermoplastic polyester resin (A) was polyethylene terephthalate, injection molding was performed under the temperature conditions of a molding temperature of 280°C and a mold temperature of 120°C, and under the molding cycle conditions of a total of an injection time and a dwelling time of 20 seconds and a cooling time of 20 seconds. For the obtained test piece for evaluation of tensile properties, the maximum tensile strength point (tensile strength) and the maximum tensile elongation point (tensile elongation) were measured according to ISO 527-1/- 2 (2012) using a tensile tester (Autograph AG-50 kNX Plus) manufactured by Shimadzu Corporation. The average value of the measured values of three test pieces was taken as the values of the tensile strength and the tensile elongation. A material having large values of tensile strength and tensile elongation was judged to have excellent mechanical properties.

### (3) Hydrolysis resistance

An ISO-1A dumbbell test piece for evaluation of tensile properties having a thickness of 4 mm was obtained under the same molding conditions as for the tensile properties in Section (2) using a SE50-DUZ injection molding machine manufactured by Sumitomo Heavy Industries, Ltd. The obtained ISO dumbbell dumbbell was placed in a highly accelerated stress test chamber EHS-411 manufactured by ESPEC CORP., set at a temperature of 121°C and a humidity of 100% RH, and subjected to a heat-moisture treatment for 50 hours. The maximum tensile strength point (tensile strength) of the heat-moisture treated molded article was measured under the same conditions as in the tensile test of Section (2), and the average value of the measured values of three test pieces was taken as the tensile strength. The value obtained by expressing the value of the maximum tensile strength point after the heat-moisture treatment with respect to the maximum tensile strength point before the heat-moisture treatment (not heat-moisture treated) in percentage was taken as the tensile strength retention rate. (Maximum tensile strength point after heat-moisture treatment/maximum tensile strength point before heat- moisture treatment (not heat-moisture treated)) × 100 = tensile strength retention rate (%)

A material having a larger value of tensile strength retention rate was judged to be more excellent in hydrolysis resistance.

### (4) Electromagnetic wave absorbing properties

A test piece for evaluation of radio wave absorbing properties measuring 80 mm in width × 80 mm in length × 2 mm in thickness was formed under the same molding conditions as for the tensile properties in Section (2) using a SE50-DUZ injection molding machine manufactured by Sumitomo Heavy Industries, Ltd.

For the measurement of the electromagnetic wave absorbing properties, the value of S21 was calculated from the measurement results of the incident wave and the transmitted wave on the test piece for evaluation of radio wave absorbing properties by the S-parameter method using a network analyzer ME7838A manufactured by Anritsu Corporation. It was judged that the larger the value of S21, that is, the larger the value of the attenuation rate, the better the radio wave absorbing properties.

### [Examples 1 to 12, Comparative Examples 1 to 9]

All the raw materials except the fibrous reinforcing material (D), namely, the thermoplastic polyester resin (A), the compound (B), the carbon-based nanofiller (C), and other raw materials were mixed in the compositions shown in Tables 1 and 2 using a co-rotating twin screw extruder (TEX30α manufactured by The Japan Steel Works, Ltd.) having a screw diameter of 30 mm and L/D of 35 with a vent, and added from a feeding portion of the twin screw extruder. The fibrous reinforcing material (D) was added through a side feeder installed between the feeding portion and the vent portion. When the thermoplastic polyester resin (A) was polybutylene terephthalate, melt mixing was performed under extrusion conditions of a kneading temperature of 250°C and a screw rotation of 150 rpm. When the thermoplastic polyester resin (A) was polyethylene terephthalate, melt mixing was performed under extrusion conditions of a kneading temperature of 260°C and a screw rotation of 150 rpm. The melt-kneaded resin composition was discharged into a strand shape, passed through a cooling bath, and pelletized by a strand cutter.

In Examples 10 and 11, melt-kneading was performed using the carbon nanotube masterbatch C-3 as a raw material. In Example 10, based on 100 parts by weight of the thermoplastic polyester resin (A), 1.2 parts by weight of the compound (B) and 4.0 parts by weight of the carbon-based nanofiller (C) were blended. In Example 11, based on 100 parts by weight of the thermoplastic polyester resin (A), 1.2 parts by weight of the compound (B) and 8.5 parts by weight of the carbon-based nanofiller (C) were blended.

The obtained pellets were dried in a hot air dryer at a temperature of 110°C for 6 hours and then evaluated by the above-described method, and the results thereof are shown in Tables 1 and 2.

**[Table 1-1]**

| | | | Example 1 | Example 2 | Example 3 | Example 4 | Example 5 | Example 6 |
|---|---|---|---|---|---|---|---|---|
| Thermoplastic polyester resin (A) | (A-1) Polybutylene terephthalate | Parts by weight | 100 | 100 | 100 | 100 | 100 | 100 |
| | (A-2) Polyethylene terephthalate | Parts by weight | - | - | - | - | - | - |
| Compound (B) | (B-1) Epoxy resin HP7200H | Parts by weight | 1.2 | 1.2 | 0.3 | 0.4 | 1.2 | 5.1 |
| | (B-1) Epoxy resin jER 1004 | Parts by weight | - | - | - | - | - | - |
| Carbon-based nanofiller (C) | (C-1) Carbon nanotube A | Parts by weight | - | - | - | - | - | - |
| | (C-2) Carbon nanotube B | Parts by weight | 1.0 | 2.5 | 4.0 | 4.0 | 4.0 | 4.0 |
| | (C-3) Carbon nanofiller masterbatch | Parts by weight | - | - | - | - | - | - |
| Fiber reinforcing material (D) | (D-1) ECS03T187 | Parts by weight | 44.9 | 44.9 | 44.9 | 44.9 | 44.9 | 44.9 |
| vinyl copolymer (E) | (E-1) Acrylonitrile/styrene/glycidyl methacrylate copolymer | Parts by weight | - | - | - | - | - | - |
| Amount of metal component in carbon-based nanofiller (C) | Total | wt% | 1.3 | 1.3 | 1.3 | 1.3 | 1.3 | 1.3 |
| | Mg | wt% | 0.00 | 0.00 | 0.00 | 0.00 | 0.00 | 0.00 |
| | Al | wt% | 0.62 | 0.62 | 0.62 | 0.62 | 0.62 | 0.62 |
| | Fe | wt% | 0.63 | 0.63 | 0.63 | 0.63 | 0.63 | 0.63 |
| Content of metal component in resin composition | Total | ppm | 85 | 245 | 340 | 330 | 345 | 320 |
| | Mg | ppm | 0 | 0 | 0 | 0 | 0 | 0 |
| | Al | ppm | 40 | 120 | 170 | 165 | 170 | 160 |
| | Fe | ppm | 45 | 125 | 170 | 165 | 175 | 160 |
| Electromagnetic wave absorbing properties | Electromagnetic wave attenuation rate of 2-mmt rectangular plate at 77 GHz | dB | 8.2 | 14.5 | 16.0 | 16.8 | 17.7 | 16.5 |
| Tensile properties | Tensile strength | MPa | 142 | 144 | 141 | 145 | 147 | 141 |
| | Tensile elongation | % | 2.1 | 2.2 | 2.1 | 2.2 | 2.3 | 2.0 |
| Hydrolysis resistance | Tensile strength retention rate after PCT50h treatment | % | 81 | 79 | 64 | 71 | 76 | 76 |

**[Table 1-2]**

| | | | Example 7 | Example 8 | Example 9 | Example 10 | Example 11 | Example 12 |
|---|---|---|---|---|---|---|---|---|
| Thermoplastic polyester resin (A) | (A-1) Polybutylene terephthalate | Parts by weight | 100 | 100 | 100 | 77 | 47 | - |
| | (A-2) Polyethylene terephthalate | Parts by weight | - | - | - | - | - | 100 |
| Compound (B) | (B-1) Epoxy resin HP7200H | Parts by weight | - | 1.2 | 1.2 | 1.2 | 1.2 | 1.2 |
| | (B-1) Epoxy resin jER 1004 | Parts by weight | 1.2 | - | - | - | - | - |
| Carbon-based nanofiller (C) | (C-1) Carbon nanotube A | Parts by weight | - | - | - | - | - | - |
| | (C-2) Carbon nanotube B | Parts by weight | 4.0 | 12.0 | 18.0 | - | - | 4.0 |
| | (C-3) Carbon nanofiller masterbatch | Parts by weight | - | - | - | 26.7 | 26.7 | |
| Fiber reinforcing material (D) | (D-1) ECS03T187 | Parts by weight | 44.9 | 44.9 | 44.9 | 44.9 | 44.9 | 44.9 |
| vinyl copolymer (E) | (E-1) Acrylonitrile/styrene/glycidyl methacrylate copolymer | Parts by weight | - | - | - | - | 30.0 | - |
| Amount of metal component in carbon-based nanofiller (C) | Total | wt% | 1.3 | 1.3 | 1.3 | 1.3 | 1.3 | 1.3 |
| | Mg | wt% | 0.00 | 0.00 | 0.00 | 0.00 | 0.00 | 0.00 |
| | Al | wt% | 0.62 | 0.62 | 0.62 | 0.62 | 0.62 | 0.62 |
| | Fe | wt% | 0.63 | 0.63 | 0.63 | 0.63 | 0.63 | 0.63 |
| Content of metal component in resin composition | Total | ppm | 345 | 800 | 1550 | 400 | 400 | 345 |
| | Mg | ppm | 0 | 0 | 0 | 0 | 0 | 0 |
| | Al | ppm | 170 | 390 | 570 | 180 | 175 | 170 |
| | Fe | ppm | 175 | 400 | 580 | 185 | 175 | 175 |
| Electromagnetic wave absorbing properties | Electromagnetic wave attenuation rate of 2-mmt rectangular plate at 77 GHz | dB | 14.3 | 19.1 | 22.2 | 18.7 | 19.5 | 14.3 |
| Tensile properties | Tensile strength | MPa | 141 | 142 | 139 | 148 | 148 | 162 |
| | Tensile elongation | % | 2.1 | 2.0 | 1.9 | 2.3 | 2.3 | 2.9 |
| Hydrolysis resistance | Tensile strength retention rate after PCT50h treatment | % | 61 | 69 | 60 | 79 | 81 | 63 |

**[Table 2-1]**

| | | | Comparative Example 1 | Comparative Example 2 | Comparative Example 3 | Comparative Example 4 | Comparative Example 5 | Comparative Example 6 |
|---|---|---|---|---|---|---|---|---|
| Thermoplastic polyester resin (A) | (A-1) Polybutylene terephthalate | Parts by weight | 100 | 100 | 100 | 100 | 100 | 100 |
| | (A-2) Polyethylene terephthalate | Parts by weight | - | - | - | - | - | - |
| Compound (B) | (B-1) Epoxy resin HP7200H | Parts by weight | - | 1.2 | - | 12.0 | 1.2 | 1.2 |
| | (B-1) Epoxy resin jER 1004 | Parts by weight | - | - | - | - | - | - |
| Carbon-based nanofiller (C) | (C-1) Carbon nanotube A | Parts by weight | - | - | - | - | 4.0 | - |
| | (C-2) Carbon nanotube B | Parts by weight | - | - | 4.0 | 4.0 | - | 30.0 |
| Fiber reinforcing material (D) | (D-1) ECS03T187 | Parts by weight | 44.9 | 44.9 | 44.9 | 44.9 | 44.9 | 44.9 |
| | (E-1) Acrylonitrile/styrene/glycidyl methacrylate copolymer | Parts by weight | | | | | | |
| Amount of metal component in carbon-based nanofiller (C) | Total | wt% | - | - | 1.3 | 1.3 | 4.0 | 1.3 |
| | Mg | wt% | - | - | 0.00 | 0.00 | 1.27 | 0.00 |
| | Al | wt% | - | - | 0.62 | 0.62 | 0.70 | 0.62 |
| | Fe | wt% | - | - | 0.63 | 0.63 | 2.00 | 0.63 |
| Content of metal component in resin composition | Total | ppm | - | - | 340.3 | 310.2 | 1070.0 | 2151.7 |
| | Mg | ppm | - | - | 0 | 0 | 340 | 2 |
| | Al | ppm | - | - | 170 | 150 | 190 | 1050 |
| | Fe | ppm | - | - | 170 | 160 | 540 | 1100 |
| Electromagnetic wave absorbing properties | Electromagnetic wave attenuation rate of 2-mmt rectangular plate at 77 GHz | dB | 0.0 | 0.0 | 14.1 | - | 13.8 | 20.8 |
| Tensile properties | Tensile strength | MPa | 140 | 141 | 142 | - | 138 | 125 |
| | Tensile elongation | % | 2.0 | 2.0 | 2.1 | - | 1.8 | 1.4 |
| Hydrolysis resistance | Tensile strength retention rate after PCT50h treatment | % | 39 | 87 | 35 | - | 40 | 47 |

**[Table 2-2]**

| | | | Comparative Example 7 | Comparative Example 8 | Comparative Example 9 |
|---|---|---|---|---|---|
| Thermoplastic polyester resin (A) | (A-1) Polybutylene terephthalate | Parts by weight | - | - | - |
| | (A-2) Polyethylene terephthalate | Parts by weight | 100 | 100 | 100 |
| Compound (B) | (B-1) Epoxy resin HP7200H | Parts by weight | - | 1.2 | 1.2 |
| | (B-1) Epoxy resin jER 1004 | Parts by weight | - | - | - |
| Carbon-based nanofiller (C) | (C-1) Carbon nanotube A | Parts by weight | - | - | 4.0 |
| | (C-2) Carbon nanotube B | Parts by weight | - | - | - |
| Fiber reinforcing material (D) | (D-1) ECS03T187 | Parts by weight | 44.9 | 44.9 | 44.9 |
| | (E-1) Acrylonitrile/styrene/glycidyl methacrylate copolymer | Parts by weight | - | | |
| Amount of metal component in carbon-based nanofiller (C) | Total | wt% | - | - | 4.0 |
| | Mg | wt% | - | - | 1.27 |
| | Al | wt% | - | - | 0.70 |
| | Fe | wt% | - | - | 2.00 |
| Content of metal component in resin composition | Total | ppm | - | - | 1070.0 |
| | Mg | ppm | - | - | 340 |
| | Al | ppm | - | - | 190 |
| | Fe | ppm | - | - | 540 |
| Electromagnetic wave absorbing properties | Electromagnetic wave attenuation rate of 2-mmt rectangular plate at 77 GHz | dB | 0.0 | 0.0 | 13.5 |
| Tensile properties | Tensile strength | MPa | 160 | 160 | 145 |
| | Tensile elongation | % | 2.7 | 2.7 | 2.1 |
| Hydrolysis resistance | Tensile strength retention rate after PCT50h treatment | % | 33 | 61 | 39 |

As compared with Comparative Examples 1 to 6, in Examples 1 to 11, the thermoplastic polyester resin (A), the compound (B), and the carbon-based nanofiller (C) were contained in specific amounts, and the metal content in the resin composition was set to a specific concentration or less, so that a polyester resin composition excellent in all of electromagnetic wave absorbing properties, mechanical strength, and hydrolysis resistance could be obtained.

More specifically, in Examples 2, 5, and 8, the content of the carbon-based nanofiller (C) was in a more preferable range as compared with Examples 1 and 9, and as a result, a polyester resin composition excellent in radio wave absorbing properties, mechanical strength, and hydrolysis resistance could be obtained.

In Example 5, the content of the carbon-based nanofiller (C) was in a more preferable range as compared with Examples 2, 8, and 9, and as a result, a polyester resin composition excellent in all of radio wave absorbing properties, mechanical strength, and hydrolysis resistance could be obtained.

In Example 5, the content of the compound (B) was in a more preferable range as compared with Examples 3 and 4, and as a result, a polyester resin composition more excellent in all of radio wave absorbing properties, mechanical strength, and hydrolysis resistance could be obtained.

In Examples 10 and 11, since the masterbatch of the carbon-based nanofiller (C) was used, the dispersibility of the carbon-based nanofiller (C) was improved as compared with Example 5, and as a result, a polyester resin composition more excellent in all of radio wave absorbing properties, mechanical strength, and hydrolysis resistance could be obtained.

As compared with Comparative Examples 7 to 9, in Example 12, the thermoplastic polyester resin (A), the compound (B), and the carbon-based nanofiller (C) were contained in specific amounts, and the metal content in the resin composition was set to a specific concentration or less, so that a polyester resin composition excellent in all of electromagnetic wave absorbing properties, mechanical strength, and hydrolysis resistance could be obtained. In Comparative Example 4, significant thickening occurred during kneading in a twin-screw extruder, and injection molding was difficult.

## Claims

1. A thermoplastic polyester resin composition comprising:
100 parts by weight of a thermoplastic polyester resin (A);
0.1 to 10 parts by weight of a compound (B) having in each molecule 2 or more functional groups capable of reacting with a carboxy group; and
0.1 to 25 parts by weight of a carbon-based nanofiller (C),
wherein a content of a metal component in the resin composition is 1,000 ppm or less.

2. The thermoplastic polyester resin composition according to claim 1, wherein the thermoplastic polyester resin (A) contains polybutylene terephthalate as a main component.

3. The thermoplastic polyester resin composition according to claim 1 or 2, wherein the compound (B) having in each molecule two or more functional groups capable of reacting with a carboxy group is an epoxy compound.

4. The thermoplastic polyester resin composition according to any one of claims 1 to 3, wherein the carbon-based nanofiller (C) is a carbon nanotube.

5. The thermoplastic polyester resin composition according to any one of claims 1 to 4, wherein the metal component in the resin composition is at least one selected from aluminum, magnesium, and iron.

6. The thermoplastic polyester resin composition according to any one of claims 1 to 5, having an electromagnetic wave absorbing property.

7. A molded article being obtained by molding the thermoplastic polyester resin composition according to any one of claims 1 to 6.
